# EUROPÄISCHE PATENTSCHRIFT

(11) **EP 1 920 474 B1**
(45) Veröffentlichungstag und Bekanntmachung des Hinweises auf die Patenterteilung: **28.10.2009**
(21) Anmeldenummer: 06777760.7
(22) Anmeldetag: 13.07.2006
(51) Int. Cl.: H01L 41/053

(54) **PIEZOAKTOR MIT EINER SELBSTZENTRIERENDEN STECKVERBINDUNG**
PIEZOELECTRIC ACTUATOR COMPRISING AN AUTOMATICALLY CENTRING PLUG-IN CONNECTION
ACTIONNEUR PIEZO-ELECTRIQUE COMPRENANT UNE FICHE DE RACCORDEMENT A CENTRAGE AUTOMATIQUE

(30) Priorität: 22.08.2005 DE 102005039553
(43) Veröffentlichungstag der Anmeldung: 14.05.2008
(73) Patentinhaber: ROBERT BOSCH GMBH, 70442 Stuttgart (DE)
(72) Erfinder: HEINZ, Rudolf, 71272 Renningen (DE); KIENZLER, Dieter, 71229 Leonberg (DE); SCHAICH, Udo, 70378 Stuttgart (DE)
(86) Internationale Anmeldenummer: PCT/EP2006/064208
(87) Internationale Veröffentlichungsnummer: WO 2007/023029

(56) Entgegenhaltungen:
- WO-A-2004/088123
- WO-A2-2005/038940

## Beschreibung

### Technisches Gebiet

Die Erfindung betrifft einen Piezoaktor, vorzugsweise ein Piezoinjektor zur Betätigung eines mechanischen Bauteils wie ein Ventil, eine Düsennadel oder dergleichen, gemäß dem Oberbegriff des Anspruchs 1.

### Stand der Technik

Es ist an sich bekannt, dass zum Aufbau eines Piezoaktors bzw. eines Piezoinjektors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoinjektor aus der DE 100 26 005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement, wie erwähnt, als Stapel mehrerer elektrisch miteinander gekoppelter piezokeramischen Schichten aufgebaut, der unter Vorspannung zwischen zwei Anschlägen gehalten ist. Jede piezokeramische Schicht ist als Piezolage zwischen zwei Innenelektroden eingefasst über die von außen eine elektrische Spannung angelegt werden kann. Aufgrund dieser elektrischen Spannung führen die piezokeramischen Schichten dann jeweils kleine Hubbewegungen in Richtung des Potentialgefälles aus, die sich zum Gesamthub des Piezoaktors addieren. Dieser Gesamthub ist über die Höhe der angelegten Spannung veränderbar und kann auf ein mechanisches Stellglied übertragen werden.

Außerdem ist auch in der EP 1 174 615 A3 ein Piezoaktor beschrieben, bei dem ein Piezoelement als Aktor für die direkte Nadelhubsteuerung eines Einspritzinjektors für einen Verbrennungsmotor vorhanden ist. Zwischen dem Piezoelement als Aktor und der Nadel sitzt lediglich ein Koppler mit einer hydraulischen Übersetzung zum Dehnungsausgleich. Mit einer Aktivierung des Piezoelements wird hierbei die unter Vorspannung zum Verschluss der Einspritzdüse gehaltene Nadel von der Düsenöffnung wegbewegt, da die Nadel direkt übersetzt der Bewegung des Aktors folgt. Piezoelement, Koppler und Nadel bilden dabei Teile eines Stellglieds, mit dessen Hilfe etwa bei einem Einspritzinjektor beispielsweise Kraftstoff oder ein anderes Fluid dosiert beispielsweise in den Brennraum eines Verbrennungsmotors eingespritzt werden kann.

Ein weiteres Beispiel ist in WO 05/66486 beschrieben.

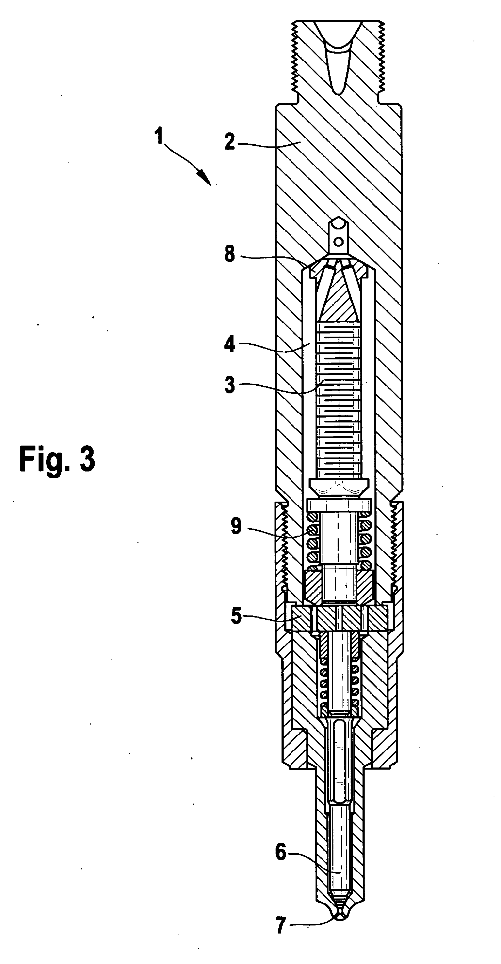

In Figur 3 ist ein prinzipieller Aufbau eines einstufigen Piezoaktors 1 nach dem Stand der Technik gezeigt, der beispielsweise zur Nadelhubsteuerung im Einspritzsystem für Kraftstoff bei einem Verbrennungsmotor eingesetzt werden kann. Im oberen Teil ist ein Haltekörper 2 vorhanden, der in seinen geometrischen Abmessungen im Wesentlichen an den jeweiligen Verwendungszweck und den spezifischen Einsatzort angepasst werden kann. Am Haltekörper 2 ist ein elektrischer Anschlussraum für hier nicht dargestelltes Steckerteil vorhanden, durch das mit einer ebenfalls spezifisch an den Anwendungsfall angepassten Steckerausführung die elektrische Spannung zur Ansteuerung eines in einem Innenraum 4 des Hattekörpers 2 angeordneten Piezoelements 3 angeschlossen werden kann.

Vom Steckerteil sind hier nicht dargestellte Drähte als elektrische Leitungen zu ebenfalls nicht dargestellten Außenelektroden am Piezoelement 3 geführt, zur elektrischen Kontaktierung des Piezoelements 3. Das Piezoelement 3 wirkt bei einer Betätigung über eine sich hier senkrecht unterhalb befindliche mechanische Anordnung mit einem Koppler 5 auf eine Düsennadel 6 derart, dass hier eine Freigabe einer Düsenöffnung 7 erfolgen kann. Ein im Inneren des Piezoaktors 1 durch den Innenraum 4 des Haltekörpers 2 geführter Kraftstoff kann somit in den Brennraum eines hier nicht dargestellten Verbrennungsmotors injiziert werden.

Das Piezoelement 3 liegt nach Figur 3 über einen Aktorfuß 8 oben an einem balligen Dichtsitz im Innenraum 4 des Haltekörpers 2 an, wobei das Piezoelement 3 zur Bewirkung eines guten Dichtsitzes mit einer Feder 9 angedrückt wird. Insbesondere bei so genannten Common-Rail (CR)-Systemen ist hier eine Hochdruckabdichtung zu einem oberhalb des Piezoelements 3 und oberhalb des Innenraums 4 in dem Haltekörper 2 angeordneten elektrischen Anschlussraum notwendig, durch den die elektrischen Leitungen zur elektrischen Kontaktierung des Piezoelements 3 geführt sind.

Einbauspezifische Anforderungen an Piezoaktoren können leichter und kostengünstiger mit einem ein Haltekörperoberteil und ein Haltekörperunterteil umfassenden, zweiteiligen Haltekörper erfüllt werden. Dabei ist das Haltekörperoberteil überwiegend an die durch die spezifischen Einbaubedingungen vorgegebenen äußeren Randbedingungen angepasst und nimmt im Wesentlichen die äußeren Anschlüsse für die elektrische Kontaktierung des Piezoelements sowie für das zu dosierende Fluid, etwa einen Kraftstoff, die der elektrischen Kontaktierung dienenden, durch das Haltekörperoberteil hindurch führenden elektrischen Leitungen, sowie den den Innenraum mit dem Anschluss für das Fluid verbindenden Strömungskanal auf.

Das Haltekörperunterteil ist demgegenüber überwiegend an die durch die Abmessungen und die Geometrie des Piezoelements und die Strömungsführung des Fluids im Innenraum vorgegebenen Randbedingungen angepasst und nimmt im Wesentlichen den Innenraum sowie das darin angeordnete Piezoelement auf.

Um die durch das Haltekörperoberteil hindurchführenden, die elektrische Kontaktierung bildenden elektrischen Leitungen auf Funktion und insbesondere Dichtheit nach Außen gegenüber dem unter hohem Druck in den Innenraum geführten Fluid vor dem endgültigen Zusammenbau des Piezoaktors testen zu können, ist das Piezoelement dabei vorzugsweise mittels einer elektrischen Steckverbindung an dem Haltekörperoberteil angeordnet.

Diese elektrische Steckverbindung ist bei einem fest am Haltekörperoberteil anordbaren Piezoelement insbesondere während des Zusammenbaus des Piezoaktors, beispielsweise beim Verschweißen oder Verkleben des Aktorfußes des Piezoelements mit dem Haltekörperoberteil, oder bei einem lösbar am Haltekörperoberteil angeordneten Piezoelement insbesondere während des Betriebs des Piezoaktors, hohen mechanischen Belastungen ausgesetzt, was zu einem mechanischen Versagen der elektrischen Steckverbindung führen kann.

Darüber hinaus wird insbesondere in einem automatisierten Prozess der Zusammenbau von Piezoelement und Haltekörperoberteil dadurch erschwert, dass die elektrische Steckverbindung vor dem Zusammenfügen der beiden Teile genau ausgerichtet werden muss, da es bei einer Fehlpositionierung während des Zusammenfügens zu einer mechanischen Beschädigung oder gar Zerstörung der elektrischen Steckverbindung kommen kann.

### Offenbarung der Erfindung

Die sich aus den Problemen des Standes der Technik ergebenden Nachteile werden bei einem erfindungsgemäßen Piezoaktor, vorzugsweise einem Piezoinjektor der eingangs genannten Gattung, vermieden durch eine zwischen Haltekörperoberteil und Piezoelement angeordnete insbesondere gegenüber zwischen dem Piezoelement und dem Haltekörperoberteil wirkenden Schubkräften belastbare mechanische Steckverbindung.

Die Erfindung weist gegenüber dem Stand der Technik den Vorteil auf, dass insbesondere beim Verschweißen oder Verkleben des Piezoelements mit dem Haltekörperoberteil die elektrische Steckverbindung in Bezug auf mechanische Beanspruchungen durch die mechanische Steckverbindung entlastet wird, wodurch sich die Gefahr einer Beschädigung oder gar Zerstörung der elektrischen Steckverbindung deutlich verringert. Darüber hinaus sind Ausführungen der mechanischen Steckverbindung denkbar, welche bereits im noch nicht zusammengebautem Zustand des Piezoelements mit dem Haltekörperoberteil die elektrische Steckverbindung schützen, beispielsweise indem die mechanische Steckverbindung an dem Bauteil, an dem die elektrische Steckverbindung überstehende Steckpins und/oder Steckhülsen aufweist ebenso Vorsprünge aufweist, welche die Steckpins und/oder Steckhülsen der elektrischen Steckverbindung vorzugsweise überragen. Dadurch wird der Umgang mit den jeweiligen Bauteilen während des Herstellungsprozesses des erfindungsgemäßen Piezoaktors vereinfacht.

Eine vorteilhafte Ausgestaltung der Erfindung sieht vor, dass die mechanische Steckverbindung eine mindestens das Piezoelement und das Haltekörperoberteil relativ zueinander zentrierende Zentriervorrichtung umfasst. Dabei ist denkbar, dass die mechanische Steckverbindung eine getrennte Zentriervorrichtung oder eine mit der mechanischen Steckverbindung kombinierte Zentriervorrichtung umfasst. Durch die gleichzeitige Zentrierung des Piezoelements gegenüber dem Haltekörperoberteil mittels der mechanischen Steckverbindung müssen die beiden Teile während des Herstellungsprozesses des Piezoaktors beim Zusammenfügen nicht so genau zueinander ausgerichtet werden und können so einfacher gehandhabt werden.

Eine weitere vorteilhafte Ausgestaltung der Erfindung sieht vor, dass die Zentriervorrichtung die elektrische Steckverbindung während des Zusammenfügens und Zentrierens des Piezoelements mit dem Haltekörperoberteil lagerichtig positioniert. Dadurch wird ein Verpolen des Piezoelements bereits beim Zusammenfügen der mechanischen Steckverbindung unterbunden. Die lagerichtige Positionierung ist beispielsweise mittels einer mechanischen Steckverbindung, welche Nasen mit unterschiedlichen Querschnittsabmessungen aufweist, welche in entsprechende Ausnehmungen am jeweils gegenüberliegenden Bauteil eingeführt werden müssen, denkbar. Dabei kann eine gleichzeitige Zentrierung beispielsweise durch eine kegel- oder konusförmige Verjüngung der dem jeweils anderen Bauteil zugewandten Enden der Nasen erreicht werden.

Eine andere vorteilhafte Ausgestaltung der Erfindung sieht vor, dass die mechanische Steckverbindung mindestens eine koaxial zu der elektrischen Steckverbindung angeordnete Hülse umfasst. Vorzugsweise ist dabei die Hülse als Zentrierhülse ausgeführt. Denkbar ist, dass die Hülse aus einem keramischen Werkstoff hergestellt ist.

Gemäß einer besonders vorteilhaften Ausgestaltung der Erfindung ist die mechanische Steckverbindung Teil der elektrischen Steckverbindung, wobei die elektrische Steckverbindung beispielsweise mindestens eine mechanisch belastbare Hülse umfasst.

Vorzugsweise ist die elektrische Steckverbindung als Poka-Yoke-Steckverbindung für einen polungsrichtigen Zusammenbau von Piezoelement und Haltekörperoberteil ausgeführt.

Eine vorteilhafte Ausgestaltung der Erfindung sieht vor, dass das Piezoelement einen den Piezolagen-Stapel in Richtung des Haltekörpers abschließenden Aktorfuß umfasst, wobei der Aktorfuß fest mit dem Haltekörper verbindbar ist, wobei die vorzugsweise als Hülse oder Zentrierhülse ausgeführte mechanische Steckverbindung in dem Aktorfuß fest angeordnet ist. Dabei ist denkbar, dass bei einer mit einer Zentriervorrichtung kombinierten mechanischen Steckverbindung gleichzeitig der Aktorfuß gegenüber dem Piezolagenstapel zentriert wird. Durch die Integration der vorzugsweise als Zentrierhülse ausgeführten kombinierten Steckund Zentriervorrichtung in den Aktorfuß ist der Bauraum für die durch das Haltekörperoberteil hindurchführenden elektrischen Leitungen im Haltekörperoberteil ausreichend und es besteht keine Kollisionsgefahr zwischen der Zentrierhülse, den elektrischen Leitungen und dem Strömungskanal. Dabei ist der Aktorfuß mit dem Haltekörper beispielsweise mittels einer Schweißverbindung und/oder einer Klebeverbindung fest verbunden.

### Kurze Beschreibung der Zeichnungen

Es zeigen:
- Figur 1: einen Längsschnitt durch einen erfindungsgemäßen Piezoaktor mit einem ein Haltekörperoberteil und ein Haltekörperunterteil umfassenden, zweiteiligen Haltekörper und einer zwischen dem Haltekörperoberteil und einem daran angeordneten Piezoelement angeordneten, eine Zentriervorrichtung umfassende, mechanischen Steckverbindung, welche Bestandteil einer elektrischen Steckverbindung ist
- Figur 2: eine Detailansicht der Steckverbindung aus Figur 1, sowie
- Figur 3: einen Piezoaktor nach dem Stand der Technik.

### Ausführungsform(en) der Erfindung

Die Erfindung wird im Folgenden am Beispiel eines Piezoaktors zur Verwendung als Common-Rail Einspritzinjektor mit direkter Nadelsteuerung beschrieben.

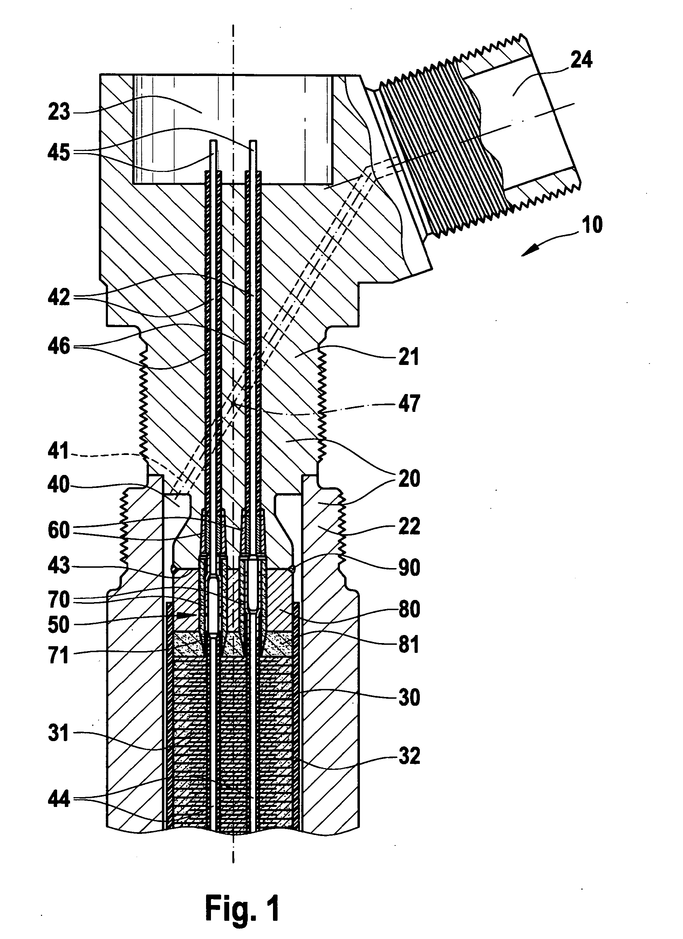

Ein in Figur 1 dargestellter erfindungsgemäßer Piezoaktor 10 besteht im Wesentlichen aus einem zweiteiligen, einen Innenraum 40 aufweisenden Haltekörper 20, sowie aus einem in dem Innenraum 40 angeordneten, durch den Haltekörper 20 hindurch elektrisch kontaktierbaren Piezoelement 30. Das Piezoelement umfasst mehrere zu einem Stapel 31 angeordnete Piezolagen. Der Haltekörper 20 umfasst ein Haltekörperoberteil 21, sowie ein Haltekörperunterteil 22.

Das Haltekörperoberteil 21 weist einen elektrischen Anschlussraum 23 zur elektrischen Kontaktierung des Piezoelements 30 mittels durch das Haltekörperoberteil 21 hindurch geführten, in den elektrischen Anschlussraum 23 mündenden elektrischen Leitungen 42 auf. Darüber hinaus weist das Haltekörperoberteil 21 einen Anschlussraum 24 zur Zufuhr eines mittels eines das Piezoelement 30 umfassenden Stellglieds dosierbaren Kraftstoffs in den Innenraum 40, sowie einen von dem Anschlussraum 24 in den Innenraum 40 führende Strömungskanal 41 auf.

Das Haltekörperunterteil 22 bildet im Wesentlichen den das Piezoelement 30 konzentrisch aufnehmenden Innenraum 40. Das Haltekörperunterteil 22 begrenzt dabei den Innenraum 40 radial, und legt damit die Länge und den Querschnitt des Innenraums 40 im Wesentlichen fest, wohingegen das Haltekörperoberteil 21 den Innenraum 40 von einer Seite her stirnseitig begrenzt. Im Haltekörperoberteil 21 sind im Wesentlichen die elektrischen Leitungen 42, der Strömungskanal 41 sowie die Anschlussräume 23, 24 angeordnet. Dadurch ist ein modularer Aufbau beliebiger Piezoaktoren 10 durch Kombination verschiedener Haltekörperoberteile 21 und Haltekörperunterteile 22 möglich.

Der elektrische Anschlussraum 23 ist in axialer Verlängerung des Piezoelements 30 angeordnet. Der Kraftstoff-Anschlussraum 24 ist seitlich am Haltekörperoberteil 21 angeordnet. Der den Kraftstoff-Anschlussraum 24 mit dem Innenraum 40 verbindende Strömungskanal 41 kreuzt die elektrischen Leitungen 42 im Kreuzungspunkt 47, wodurch der Bauraum für die elektrische Kontaktierung des Piezoelements stark beschränkt ist.

Der Strömungskanal 41 mündet in den zwischen dem Piezoelement 30 und dem das Piezoelement 30 konzentrisch umhüllenden Haltekörperunterteils 22 verbleibenden Ringraum des Innenraums 40. Im Betrieb ist somit das eine in ihren Innenquerschnittsabmessungen den Außenquerschnittsabmessungen des Piezoelements 30 entsprechende Isolationshülse 32 umfassende Piezoelement 30 von dem durch den verbleibenden Ringraum des Innenraums 40 strömenden Kraftstoff umgeben. Eine derartige Anordnung wird als nasse Anordnung bezeichnet.

Das Piezoelement 30 ist mittels einer elektrischen Steckverbindung 50 mit den in dem Haltekörperoberteil 21 angeordneten Leitungen 42 elektrisch verbunden.

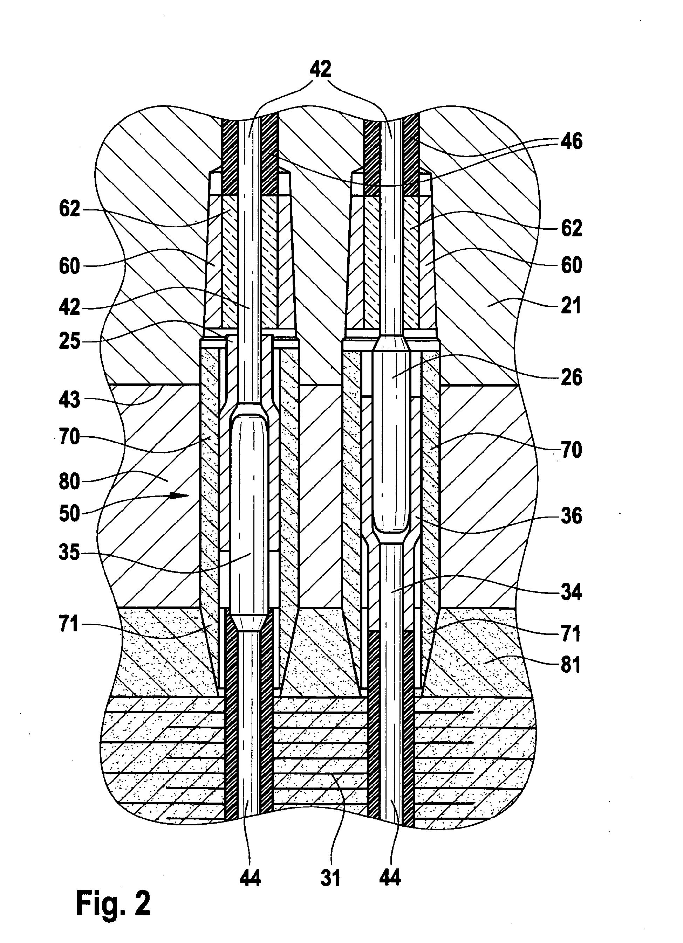

Die in Figur 2 dargestellte elektrische Steckverbindung 50 ist dabei zwischen dem Haltekörperoberteil 21 und dem Piezoelement 30 angeordnet. Das Piezoelement 30 umfasst einen, den nicht näher dargestellten Piezolagen-Stapel 31 in Richtung des Haltekörperoberteils 21 stirnseitig abschließenden Aktorfuß 80, an dem der den piezoelementseitigen Teil der elektrischen Steckverbindung 50 bildende Steckpin 35 und die Steckhülse 36 angeordnet sind, sowie eine zwischen Aktorfuß 80 und dem Piezolagen-Stapel 31 angeordnete keramische Isolation 81. Elektroden 44 dienen der inneren Kontaktierung der Piezolagen. Der haltekörperseitige Teil der Steckverbindung 50 ist an einer den Innenraum 40 stirnseitig begrenzenden Stirnwand 43 des Haltekörperoberteils 21 angeordnet.

Im Haltekörperoberteil 21 sind die das Gegenstück zu dem Steckpin 35 und der Steckhülse 36 bildende Steckhülse 25 und der Steckpin 26 angeordnet.

Ebenfalls zwischen dem Piezoelement 30 und dem Haltekörperoberteil 21 ist eine mechanische Steckverbindung angeordnet, welche insbesondere während des Zusammenbaus von Piezoelement 30 und Haltekörperoberteil 21 zwischen den beiden Teilen auftretende Schubkräfte überträgt, und so von der elektrischen Steckverbindung 50 fernhält.

Die mechanische Steckverbindung ist als Bestandteil der elektrischen Steckverbindung 50 ausgeführt und besteht im Wesentlichen aus zwei Zentrierhülsen 70.

Die konisch zulaufenden Zentrierhülsen 70 sind jeweils konzentrisch zu der am Piezoelement 30 angeordneten Steckhülse 36 und dem Steckpin 35, sowie konzentrisch zu dem am Haltekörperoberteil 21 angeordneten Steckpin 26 und der Steckhülse 25 angeordnet. Dadurch entsteht eine elektrische Steckverbindung 50 mit integrierter mechanischer Steckverbindung und Zentrierung. Die Zentrierhülsen 70 ragen dabei aus dem Aktorfuß 80 heraus in das Haltekörperoberteil 21 hinein. Sie sind im Aktorfuß 80 fest angeordnet. Dadurch verbleibt viel Bauraum im Haltekörperoberteil 21 für die dort angeordneten Teile der Steckverbindung 50, wie etwa den haltekörperseitigen Steckpin 26 und die haltekörperseitige Steckbuchse 25, die Anordnung der elektrischen Leitungen, sowie für den Strömungskanal 41, insbesondere im Hinblick auf die Lage des Kreuzungspunkts 47 mit den elektrischen Leitungen 42.

Die Zentrierhülsen 70 ragen zudem jeweils mit ihrem sich konisch verjüngenden Ende 71 in eine jeweils entsprechende, konzentrisch zu dem piezoelementseitigen Steckpin 35 und der Steckhülse 36 in der keramischen Isolation 81 angeordnete Ausnehmung in die keramische Isolation 81. Dadurch wird darüber hinaus der Aktorfuß 80 gegenüber der keramischen Isolation 81 und damit gegenüber dem Piezolagenstapel 31 zentriert.

Die haltekörperseitige Steckhülse 25 und der haltekörperseitige Steckpin 26 sind mit den durch im Haltekörperoberteil 21 angeordnete Bohrungen führenden elektrischen Leitungen 42 elektrisch leitend verbunden. Die der Steckverbindung 50 abgewandten, freien Enden 45 der elektrischen Leitungen 42 sind mit Isolierungen 46 zur elektrischen Isolation gegenüber dem Haltekörperoberteil 21 versehen und können in dem Anschlussraum 23 mit einem Stecker kontaktiert werden.

Um ein Austreten von Kraftstoff aus dem Innenraum 40 in den elektrischen Anschlussraum 23 zu vermeiden, sind in dem Haltekörperoberteil 21 darüber hinaus mittels einer Glaseinschmelzung 62 mit den elektrischen Leitungen 42 kraftstoffdicht verbundene Dichtbuchsen 60 hydraulisch verpresst.

Zur weiteren Verbesserung der Abdichtung des Innenraums 40 gegenüber dem elektrischen Anschlussraum und der Umgebung ist das Piezoelement 30 an der den Innenraum 40 stirnseitig begrenzenden Stirnwand 43 des Haltekörperoberteils 21 fest angeordnet. Zur festen Anordnung des Piezoelements 30 an der Stirnwand 43 des Haltekörperoberteils 21 dient eine den Aktorfuß 80 fest mit der Stirnwand 43 verbindenden Schweißverbindung 90.

Alternativ kann das Piezoelement 30 auch mittels einer Klebeverbindung zwischen Aktorfuß 80 und Stirnwand 43 fest mit dem Haltekörperoberteil 21 verbunden werden.

Durch eine feste, umlaufende Verbindung, wie etwa durch die Schweißverbindung 90, wird eine absolute Hochdruckdichtheit des Innenraums 40 gegenüber dem elektrischen Anschlussraum 23 und gegenüber der Umgebung erreicht.

Durch die kombinierte elektrische Steckverbindung 50 mit integrierter mechanischer Steckverbindung und Zentrierung wird ein lagerichtiges und zentriertes Zusammenfügen des Piezoelements 30 an das Haltekörperoberteil 21 ermöglicht. Anschließend ist eine präzise Verschweißung des Aktorfußes 80 mit dem Haltekörperoberteil 21 möglich.

Wichtig ist zu bemerken, dass durch die Erfindung eine sichere steckbare elektrische Verbindung mit integrierter mechanischer Steckverbindung und Zentrierung zwischen dem Aktorfuß 80 und dem Haltekörperoberteil 21, sowie eine Zentrierung des Aktorfußes 80 zum Piezolagen-Stapel 31 herstellbar ist.

Zwei durch das Haltekörperoberteil 21 hindurchführende, symmetrische kleine Bohrungen für die elektrischen Leitungen 42 können dabei von unten oder oben, oder von unten und oben hergestellt werden, wodurch die Länge des Haltekörperoberteil 21 je nach Anwendungsfall und Einbausituation des Piezoaktors 10 angepasst werden kann.

Die erfindungsgemäße kombinierte, die elektrische Steckverbindung 50, die mechanische Steckverbindung, sowie die Zentriervorrichtung umfassende Steck- und Zentriereinheit ist vollkommen im Aktorfuß 80 des Piezoelements 30 integriert und beinhaltet eine Zentrierung des Aktorfußes 80 zum Piezolagen-Stapel 31 durch die beiden Konen 71 der Zentrierhülsen 70. Indem die Zentrierhülsen 70 auf der dem Piezolagenstapel 31 abgewandten Seite des Aktorfußes 80 weiter als der Steckpin 35 oder die Steckhülse 36 aus dem Piezoelement 30 herausragen, besteht beim Umgang mit dem Piezoelement 30 und beim Zusammenfügen des Piezoelements 30 mit dem Haltekörperoberteil 21 keine Gefahr, den Steckpin 35 oder die Steckhülse 36 abzuknicken.

Dadurch dass die kombinierte Steck- und Zentriereinheit in den Aktorfuß 80 des Piezoelements 30 integriert ist, steht mehr Bauraum für die elektrischen Leitungen 42 sowie für den den Steckpin 26 und die Steckhülse 25 umfassenden haltekörperseitigen Teil der elektrischen Steckverbindung 50 und den Strömungskanal im Haltekörperoberteil 21 zur Verfügung. Dadurch kann die Kollisionsgefahr zwischen dem Strömungskanal 41 und den elektrischen Leitungen 42 im Haltekörperoberteil 21 verringert werden.

Durch die Zentrierhülsen 70 der erfindungsgemäßen kombinierten Steck- und Zentriereinheit ist beim Zusammenbau des Piezoelements 30 mit dem Haltekörperoberteil 21 gleichzeitig eine Zentrierung der beiden Teile gegeneinander gegeben.

Die elektrische Steckverbindung in Figur 2 ist als Poka-Yoke für einen polungsrichtigen Zusammenbau ausgebildet.

Das Piezoelement 30 ist mit der passiven keramischen Isolation 81, dem Pin 34 mit angelöteter Steckhülse 36, und dem Steckpin 35 bestückt. Die keramischen Zentrierhülsen 70 werden über die Steckhülse 36 und den Steckpin 35 gesteckt, und in einer im Aktorfuß 80 angeordneten konusförmigen Ausnehmung zentriert. Der Aktorfuß 80 wird über die keramischen Zentrierhülsen 70 gebracht und zu einer Einheit mit der keramischen Isolation und dem Piezolagenstapel 31 verklebt.

Das Piezoelement kann jetzt über die Steckhülse 36 und den Steckpin 35 polarisiert werden, beispielsweise ist die Steckhülse 36 der Pluspol und der Steckpin 35 der Minuspol. Die Unsymmetrie der beiden Steckkontakte stellt eine sichere Poka-Yoke-Verbindung dar.

Die beiden Dichtbuchsen 60 werden im Haltekörperoberteil 21 hydraulisch verpresst und gewährleisten die geforderte absolute Druckdichtheit des Innenraums 40 nach außen gegenüber dem elektrischen Anschlussraum 23 und gegenüber der Umgebung.

Das Haltekörperoberteil 21 kann nun einzeln auf Druckdichtheit geprüft werden.

Die Isolierungen 46 werden in das Haltekörperoberteil 21 eingebracht, ebenso wie die elektrischen Leitungen 42. Die elektrischen Leitungen 42 können daraufhin im elektrischen Anschlussraum 23 kontaktiert werden.

Die Zentrierung des Piezoelements 30 zum Haltekörperoberteil 21 ist über die beiden aus dem Aktorfuß 80 in das Haltekörperoberteil 21 hineinragenden keramischen Zentrierhülsen 70 lagerichtig und positionsrichtig gegeben, woraufhin die Schweißverbindung 90 zwischen Aktorfuß 80 und Haltekörperoberteil 21 ausgeführt werden kann.

### Gewerbliche Anwendbarkeit

Die Erfindung ist insbesondere im Bereich der Herstellung von Piezoaktoren zur Verwendung in Verbindung mit Einspritzinjektoren für Verbrennungsmotoren gewerblich anwendbar.

## Patentansprüche

1. Piezoaktor (10) umfassend einen einen Innenraum (40) aufweisenden, ein Haltekörperoberteil und ein Haltekörperunterteil umfassenden Haltekörper (20) sowie ein in dem Innenraum (40) an dem Haltekörperoberteil (21) angeordnetes Piezoelement (30), welches durch den Haltekörper (20) hindurch elektrisch kontaktierbar ist, wobei das Haltekörperoberteil (21) einen oder mehrere Anschlüsse (23) für die elektrische Kontaktierung (42) des Piezoelements (30) aufweist und zwischen dem Piezoelement (30) und dem Haltekörperoberteil (21) eine elektrische Steckverbindung (50) angeordnet ist, **gekennzeichnet durch** eine zwischen Haltekörperoberteil (21) und Piezoelement (30) angeordnete mechanische Steckverbindung (70).

2. Piezoaktor nach Anspruch 1, **dadurch gekennzeichnet,**
**dass** die mechanische Steckverbindung eine Zentriervorrichtung (70) umfasst.

3. Piezoaktor nach Anspruch 2, **dadurch gekennzeichnet,**
**dass** die elektrische Steckverbindung (50) während des Zusammenfügens und Zentrierens des Piezoelements (30) mit dem Haltekörperoberteil (21) mittels der Zentriervorrichtung (70) lagerichtig positionierbar ist.

4. Piezoaktor nach einem der Ansprüche 1, 2 oder 3, **dadurch gekennzeichnet, dass** die mechanische Steckverbindung mindestens eine konzentrisch zu der elektrischen Steckverbindung (50) angeordnete Hülse (70) umfasst.

5. Piezoaktor nach Anspruch 4, **dadurch gekennzeichnet,**
**dass** die Hülse als Zentrierhülse (70) ausgeführt ist.

6. Piezoaktor nach Anspruch 4 oder 5, **dadurch gekennzeichnet,**
**dass** die Hülse (70) aus einem keramischen Werkstoff hergestellt ist.

7. Piezoaktor nach einem der vorhergehenden Ansprüche, **dadurch gekennzeichnet,**
**dass** die mechanische Steckverbindung (70) Teil der elektrischen Steckverbindung (50) ist.

8. Piezoaktor nach einem der vorhergehenden Ansprüche, **dadurch gekennzeichnet,**
**dass** die elektrische Steckverbindung (50) als Poka-Yoke-Steckverbindung (25, 26, 35, 36) ausgeführt ist.

9. Piezoaktor nach einem der vorhergehenden Ansprüche, **dadurch gekennzeichnet,**
**dass** das Piezoelement (30) einen Aktorfuß (80) umfasst, durch den das Piezoelement (30) in Richtung des Haltekörpers (20, 21) abgeschlossen wird, wobei der Aktorfuß (80) fest mit dem Haltekörper (20, 21) verbindbar ist, und die mechanische Steckverbindung (70) in dem Aktorfuß (80) fest angeordnet ist.

10. Piezoaktor nach Anspruch 9, **dadurch gekennzeichnet,**
**dass** der Aktorfuß (80) mit dem Haltekörper (20, 21) mittels einer Schweißverbindung (90) fest verbunden ist.

11. Piezoaktor nach Anspruch 9, **dadurch gekennzeichnet,**
**dass** der Aktorfuß (80) mit dem Haltekörper (20, 21) mittels einer Klebeverbindung fest verbunden ist.

## Claims

1. Piezo-actuator (10), comprising a holding body (20) having an inner space (40) and comprising a holding-body upper part and a holding-body lower part, and also a piezo-element (30) which is arranged in the inner space (40) on the holding-body upper part (21) which is electrically contactable through the holding body (20), the holding-body upper part (21) having one or more terminals (23) for electrical contacting (42) of the piezo-element (30), and an electrical plug connection (50) being arranged between the piezoelement (30) and the holding-body upper part (21), **characterized by** a mechanical plug connection (70) arranged between the holding-body upper part (21) and piezo-element (30).

2. Piezo-actuator according to Claim 1, **characterized in that** the mechanical plug connection comprises a centring device (70).

3. Piezo-actuator according to Claim 2, **characterized in that** the electrical plug conenction (50) can be correctly positioned by means of the centring device (70) while the piezo-element (30) is being joined together and centred with the holding-body upper part (21).

4. Piezo-actuator according to one of Claims 1, 2 or 3, **characterized in that** the mechanical plug conenction comprises at least one sleeve (70) arranged concentrically with respect to the electrical plug connection (50).

5. Piezo-actuator according to Claim 4, **characterized in that** the sleeve is designed as a centring sleeve (70).

6. Piezo-actuator according to Claim 4 or 5,
**characterized in that** the sleeve (70) is produced from a ceramic material.

7. Piezo-actuator according to one of the preceding claims, **characterized in that** the mechanical plug conenction (70) is part of the electrical plug connection (50).

8. Piezo-actuator according to one of the preceding claims, **characterized in that** the electrical plug connection (50) is designed as a poka-yoke plug connection (25, 26, 35, 36).

9. Piezo-actuator according to one of the preceding claims, **characterized in that** the piezo-element (30) comprises an actuator foot (80), by means of which the piezo-element (30) is closed off in the direction of the holding body (20, 21), the actuator foot (80) being connectable fixedly to the holding body (20, 21), and the mechanical plug connection (70) being arranged fixedly in the actuator foot (80).

10. Piezo-actuator according to Claim 9, **characterized in that** the actuator foot (80) is connected fixedly to the holding body (20, 21) by means of a welded joint (90).

11. Piezo-actuator according to Claim 9, **characterized in that** the actuator foot (80) is connected fixedly to the holding body (20, 21) by means of an adhesive joint.

## Revendications

1. Piézoactionneur (10) comprenant un corps de support (20) doté d'une cavité (40), d'une partie supérieure de corps de support et d'une partie inférieure de corps de support, ainsi qu'un piézoélément (30) disposé dans la cavité (40) et contre la partie supérieure (21) du corps de support et apte à être mis en contact électrique à travers le corps de support (20),
la partie supérieure (21) du corps de support présentant une ou plusieurs bornes de raccordement (23) qui assurent le contact électrique (42) avec le piézoélément (30) et une fiche de raccordement électrique (50) étant disposée entre le piézoélément (30) et la partie supérieure (21) du corps de support,
**caractérisé par**
une fiche de raccordement mécanique (70) disposée entre la partie supérieure (21) du corps de support et le piézoélément (30).

2. Piézoactionneur selon la revendication 1, **caractérisé en ce que** la fiche de raccordement mécanique comporte un dispositif de centrage (70).

3. Piézoactionneur selon la revendication 2, **caractérisé en ce que** le dispositif de centrage (70) permet de positionner la fiche de raccordement électrique (50) en position correcte pendant l'assemblage et le centrage du piézoélément (30) sur la partie supérieure (21) du corps de support.

4. Piézoactionneur selon l'une des revendications 1, 2 ou 3, **caractérisé en ce que** la fiche de raccordement mécanique comporte au moins une douille (70) disposée concentriquement par rapport à la fiche de raccordement électrique (50).

5. Piézoactionneur selon la revendication 4, **caractérisé en ce que** la douille est configurée comme douille de centrage (70).

6. Piézoactionneur selon les revendications 4 ou 5, **caractérisé en ce que** la douille (70) est réalisée en un matériau céramique.

7. Piézoactionneur selon l'une des revendications précédentes, **caractérisé en ce que** la fiche de raccordement mécanique (70) fait partie de la fiche de raccordement électrique (50).

8. Piézoactionneur selon l'une des revendications précédentes, **caractérisé en ce que** la fiche de raccordement électrique (50) est configurée sous la forme d'une fiche de raccordement dite "Poka-Yoke" (25, 26, 35, 36).

9. Piézoactionneur selon l'une des revendications précédentes, **caractérisé en ce que** le piézoactionneur (30) présente un pied d'actionneur (80) qui ferme le piézoélément (30) en direction du corps de support (20, 21), le pied d'actionneur (80) pouvant être relié solidairement au corps de support (20, 21) et la fiche de raccordement mécanique (70) étant disposée fixement dans le pied d'actionneur (80).

10. Piézoactionneur selon la revendication 9, **caractérisé en ce que** le pied d'actionneur (80) est relié solidairement au corps de support (20, 21) au moyen d'une liaison soudée (90).

11. Piézoactionneur selon la revendication 9, **caractérisé en ce que** le pied d'actionneur (80) est relié solidairement au corps de support (20, 21) au moyen d'une liaison collée.
